(19) Europäisches Patentamt / European Patent Office / Office européen des brevets

(11) **EP 2 246 899 A1**

(12) **EUROPEAN PATENT APPLICATION**
published in accordance with Art. 153(4) EPC

(43) Date of publication:
**03.11.2010 Bulletin 2010/44**

(51) Int Cl.:
*H01L 31/04* (2006.01)

(21) Application number: **09713551.1**

(22) Date of filing: **17.02.2009**

(86) International application number:
**PCT/JP2009/052692**

(87) International publication number:
**WO 2009/104601 (27.08.2009 Gazette 2009/35)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **18.02.2008 JP 2008036498**

(71) Applicant: **Sharp Kabushiki Kaisha**
**Osaka-shi, Osaka 545-8522 (JP)**

(72) Inventor: **SHIMIZU, Akira**
**Osaka 545-8522 (JP)**

(74) Representative: **Müller - Hoffmann & Partner**
**Patentanwälte**
**Innere Wiener Strasse 17**
**81667 München (DE)**

(54) **THIN FILM SOLAR CELL MODULE**

(57) To provide an integrated thin-film solar cell that prevents deterioration of hotspot resistance and has a high output voltage.

A thin-film solar cell module comprising: a thin-film solar cell string comprising a plurality of thin-film solar cell elements interconnected in series, each of the thin-film solar cell elements including a surface electrode, a photoelectric conversion layer, and a back surface electrode laminated in this order, the thin-film solar cell module being configured so that the number of stages n of the series connection of the thin-film solar cell elements in the thin-film solar cell string satisfies the following formula (1):

$$n < Rshm / 2.5 / Vpm \times Ipm + 1 \quad (1),$$

wherein Rshm is the most frequent short-circuit resistance value of the thin-film solar cell elements;
Vpm is an optimum operation voltage of the thin-film solar cell elements; and
Ipm is an optimum operation current of the thin-film solar cell elements.

FIG. 3

EP 2 246 899 A1

**Description**

TECHNICAL FIELD

The present invention relates to a thin-film solar cell module comprising a thin-film solar cell string comprising a plurality of thin-film solar cell elements connected in series. In particular, the thin-film solar cell module of the present invention is adapted to have high hotspot resistance.

BACKGROUND ART

A measure for increasing an output voltage of a solar cell module by connecting solar cells in series is well known. In particular, thin-film solar cell modules based on silicons including amorphous silicons, microcrystalline silicons, and polycrystalline thin-film silicons; and thin-film solar cell modules based on compounds including Cu(InGa)Se2, CdTe, and CuInSe2 can be produced while connecting a plurality of thin-film solar cell elements in series on one substrate by adopting an appropriate scribe structure. Actually, modules having such a structure have been already marketed. However, the size of substrates of thin-film solar cell modules has been relatively small so far, and integration loss grows too big if the number of integrated cells is increased aggressively. Therefore, it has been difficult to increase the number of integration stages. In addition, there have not been so many applications that require a high voltage of 200 V or more. Therefore, there have not been produced so many thin-film solar cell modules that output a high voltage of 200 V or more. In the trend of the solar cell industry of these days, however, thin-film solar cell modules have been upsized as demand for large-scale power generating systems for industrial use grows, and the environment that facilitates production of thin-film solar cell modules of high voltage has been being developed. In addition, demand has been increasing for alternating current high voltage output solar cell modules such as PVMIPS (Photovoltaic Module with Integrated Power Conversion System: inverter built-in solar cell module) and high voltage solar cell modules that allow direct input to an inverter.

Therefore, there has arisen need for production of thin-film solar cell modules of high voltage output. However, it is known that a hotspot phenomenon occurs in thin-film solar cell modules of high voltage output. (See Patent Document 1, for example)

[Patent Document 1] Japanese Unexamined Patent Publication No. 2001-68713

DISCLOSURE OF THE INVENTION

PROBLEMS TO BE SOLVED BY THE INVENTION

Patent Document 1 is to increase reliability by specifying a short-circuit current.
However, results of our study on thin-film solar cell modules of high voltage output have revealed that problems arise in terms of hotspot resistance when a high voltage is obtained by merely increasing the number of integration stages of solar cell elements as an extension of conventional techniques.
Specifically, it has been confirmed that the following phenomenon occurs.
When shade touches a thin-film solar cell module in operation, power generated by solar cell elements in a lighted region will be consumed in solar cell elements in a shaded region. As a result, a large backward voltage is generated in the solar cell elements in the shaded region, and the solar cell elements in the shaded region generate heat, causing peel-off and deterioration of films, and glass cracks. Then, in the case of a conventional thin-film solar cell module of an output voltage up to approximately several 10 V, a short-circuited region in the film surface of the solar cell elements mainly generates heat. Therefore, critical conditions such as glass cracks are prevented from occurring if the thin-film solar cell module is designed so that the power to be concentrated on the heat generating region will be a predetermined value or lower. In addition, even when peel-off of a film or the like occurred, the short-circuited region in the film surface was burnt off to work for improvement of F.F. (fill factor) of the solar cell elements, compensating area loss due to the peel-off, and therefore the output characteristics did not deteriorate significantly.

In proportion to increase of the output voltage, the thin-film solar cell module of high voltage output has an increased backward voltage to be applied to the solar cell elements in the shaded region, and heat is generated also in a region having higher resistance. In this case, it is insufficient as measures only to specify the current as in the case of Patent Document 1, because heat is generated in the high-resistance region in a state of high voltage and low current.
Furthermore, in such a thin-film solar cell module, a phenomenon has been confirmed where main heat generation shifts to a scribe line, not in the film surface of the thin-film solar cell elements. When peel-off occurs in a scribe line, the peel-off may progress to the whole thin-film solar cell elements, starting from the scribe line. Therefore, that is not very preferable in terms of lifetime and reliability of the thin-film solar cell module. Besides, such peel-off, when occurring, involves neighboring thin-film solar cell elements that were not originally a factor causing deterioration of characteristics. As a result, there has been a problem in that the output characteristics of the thin-film solar cell module are deteriorated in proportion to decrease of the power generating area due to peel-off.

The present invention has been achieved in view of such a situation, and when producing a thin-film solar cell module of high voltage output, the present invention is to control the number of integration stages of solar cell elements so that the output voltage is an appropriate value or less rather than to simply increase the number of integration stages by following convention. An object of the present invention is to thus prevent deterioration of hotspot resistance and to provide an integrated thin-film solar cell module having high hotspot resistance and a high output voltage by combining a plurality of the modules.

MEANS FOR SOLVING THE PROBLEMS

In order to solve the above-described problems, the thin-film solar cell module of the present invention comprises a thin-film solar cell string comprising thin-film solar cell elements interconnected in series, each of the thin-film solar cell elements including a surface electrode, a photoelectric conversion layer, and a back surface electrode laminated in this order, the thin-film solar cell module being configured so that the number of stages n of the series connection of the thin-film solar cell elements in the thin-film solar cell string satisfies the following formula (1):

$$n < Rshm \ / \ 2.5 \ / \ Vpm \times Ipm + 1 \quad (1),$$

wherein Rshm is the most frequent short-circuit resistance value of the thin-film solar cell elements;
Vpm is an optimum operation voltage of the thin-film solar cell elements;
and Ipm is an optimum operation current of the thin-film solar cell elements.

EFFECTS OF THE INVENTION

According to the thin-film solar cell module of the present invention, it is possible to achieve a thin-film solar cell module of high voltage output, while maintaining hotspot resistance.

BRIEF DESCRIPTION OF THE DRAWINGS

FIG. 1 is an explanatory diagram of a measurement circuit of a short-circuit resistance Rsh.
FIG. 2 is an explanatory diagram of a method for measuring the short-circuit resistance Rsh.
FIG. 3 is a diagram illustrating the relationship between the short-circuit resistances Rsh and Prsh.
FIG. 4 is a diagram illustrating distribution of the short-circuit resistance Rsh of a thin-film solar cell module.
FIG. 5 is a plan view and a sectional view of a thin-film solar cell module of Embodiment 1.
FIG. 6 is a circuit diagram of the thin-film solar cell module of Embodiment 1.
FIG. 7 is a plan view and a sectional view of a thin-film solar cell module of Embodiment 2.
FIG. 8 is a circuit diagram of the thin-film solar cell module of Embodiment 2.
FIG. 9 is a plan view and a sectional view of a thin-film solar cell module of Embodiment 3.
FIG. 10 is a circuit diagram of the thin-film solar cell module of Embodiment 3.

DESCRIPTION OF THE REFERENCE NUMERALS

| | |
|---|---|
| 1 | Supporting substrate |
| 2 | First electrode |
| 3 | Dividing scribe line |
| 4 | Photoelectric conversion layer |
| 5 | Second electrode |
| 5c | Contact line |
| 6 | Cell dividing groove |
| 7 | Metal electrode |

| 8 | String dividing groove |
| 9 | Cover glass |
| 11 | Terminal box |
| 12 | Diode |
| 13 | Output terminal |
| 14, 15, 21 to 25, 31 to 35 | Lead wires |

BEST MODE FOR CARRYING OUT THE INVENTION

The thin-film solar cell module of the present invention comprises a thin-film solar cell string comprising thin-film solar cell elements interconnected in series, each of the thin-film solar cell elements including a surface electrode, a photoelectric conversion layer, and a back surface electrode laminated in this order, the thin-film solar cell module being configured so that the number of stages n of the series connection of the thin-film solar cell elements in the thin-film solar cell string satisfies the following formula (1):

$$n < Rshm / 2.5 / Vpm \times Ipm + 1 \quad (1),$$

wherein Rshm is the most frequent short-circuit resistance value of the thin-film solar cell elements;
Vpm is an optimum operation voltage of the thin-film solar cell elements; and
Ipm is an optimum operation current of the thin-film solar cell elements.

When in operation, a solar cell array having the thin-film solar cell module of the above-described configuration built therein is in a state where the output of the thin-film solar cell string is short-circuited by a bypass diode, when the thin-film solar cell string comprising n stages of solar cell elements integrated is in a hotspot state due to one stage of thin-film solar cell elements of those being in shade. An equivalent circuit in the module in this case is in a state where (n-1) stages of thin-film solar cell elements in light have one stage of thin-film solar cell elements not in light connected thereto as a load. Therefore, most power generated in the region being in light in the thin-film solar cell string will be consumed in the thin-film solar cell elements in shade, without being taken out of the thin-film solar cell string. Then, when the reverse breakdown voltage is sufficiently high in the normal region of the thin-film solar cell elements in shade, the current that flows to the thin-film solar cell elements goes to a region within the surface short-circuited by dust, flaws, and protrusions, and a region of low resistance around the laser scribing and the like.
Measures of how easy the current flows include the short-circuit resistance to be worked out from current-voltage characteristics when a backward voltage of approximately 0 to several V is applied to the thin-film solar cell elements. When the short-circuit resistance is Rsh [Ω], the power is most concentrated on the short-circuit part when the short-circuit resistance Rsh is equal to an optimum load Rshpm with respect to the (n-1) stages of cells in light. Therefore, the module needs to be designed so that the short-circuit resistance Rsh is prevented from being close to the value.
Here, a measuring method of the short-circuit resistance Rsh will be described.
The short-circuit resistance Rsh of the solar cell module can be measured according to the following steps:

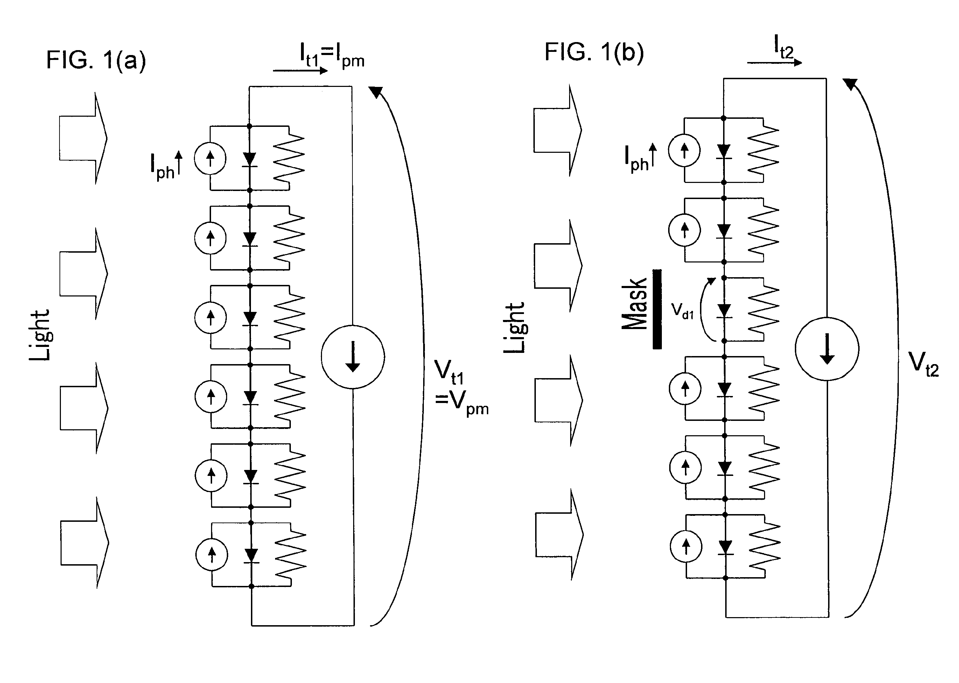

(1) In the case of a module having a blocking diode built therein, the blocking diode is removed.
(2) In the case of a module having a bypass diode(s) built therein, all the bypass diode(s) is removed.
(3) In the case of a module in which a plurality of bypass diodes are used, the module is processed so that output can be taken out in a unit in which the bypass diodes were connected. In the following test, the evaluation is performed by the unit in which the bypass diodes were connected. In the case of one or no bypass diode, the evaluation is performed by the module.
(4) When the evaluation object includes a plurality of cell strings having a plurality of cells connected in series, and they have a configuration of parallel connection, all the strings other than one string to be evaluated are covered so as not to be in light, or the parallel connection is disconnected so that only one string to be evaluated can be evaluated in the following evaluation.
(5) The evaluation object is put in light of 1000 W/m$^2$ (or 1000 $\pm$ 200 W/m$^2$) with the use of a fixed light solar simulator or outdoor light and held until temperature becomes stable.
(6) An I-V curve is measured under a condition of stable temperature and illuminance. Thereby, Vpm and Ipm are determined. The output current for each solar cell is Iph.
(7) A current of It1 = Ipm is applied from outside with the use of a constant-current source while keeping the module in the fixed light. At this time, an output voltage Vt1 of the evaluation object is Vpm. (See FIG. 1(a))
(8) One stage of cells are masked and measured for an output voltage Vt2 then. The output voltage of the masked cells is Vd1. (See FIG. 1(b)) Since heat may be generated to break the cells if the reverse breakdown voltage of the cells is high here, Vt2 is given an appropriate limit so as not to be Vt2 < 0. When the limit is reached, It2 at the time of Vt2 = 0 is recorded, and a voltage at the time when the current is It2 is obtained from the I-V curve measured in (6) to determine Vt1.

(9) When the number of series connection stages in the cell string is n,

$$Vd1 = Vt2 \text{ ? } (n\text{-}1) \text{ / } n \times Vt1;$$

and

$$Rsh = \text{-}Vd1 \text{ / } It2,$$

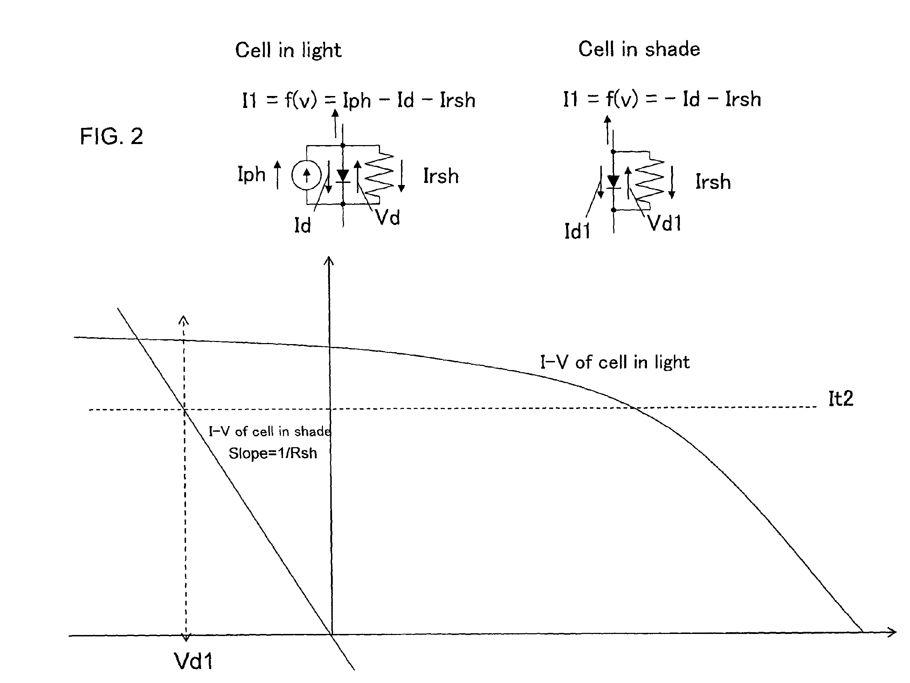

whereby Rsh of the masked cells is determined. (10) The evaluation described in (8) and (9) is repeated for all cells to measure Rsh of each cell. FIG. 2 illustrates a current I1 and an I-V property of a cell in light. FIG. 2 also illustrates a current I1 and an I-V property, that is, a slope 1/Rsh of a cell in shade.

Thus, it is very likely that the short-circuit resistance Rsh damages the solar cell module, because the voltage-current is measured after the solar cell module is completed, the blocking diode and the bypass diode are removed from the completed solar cell module, and at least one stage of cells is put in shade.

As described above, therefore, may be adopted a method for measuring the short-circuit resistance Rsh by applying a reverse bias to the solar cell elements constituting the solar cell module and, by a leakage current that flows at the time, assuming: short-circuit resistance Rsh $\cong$ reverse bias voltage / leakage current. It is desirable that a voltage considered possible in a hotspot is applied as the reverse bias voltage being applied then. When the reverse breakdown voltage of each cell is high or unknown, however, it is desirable that the test is carried out with a voltage lower than a voltage considered possible in an actual hotspot. In the case of a tandem cell of an amorphous silicon and a micro crystallite, it is desirable to carry out the test with a backward voltage of 5 to 8 V.

For example, an optimum load Rshpm is reached as in the following formula (2), which is the worst, where an optimum operation voltage is Vpm [V] and an optimum operation current is Ipm [A] with respect to one stage of thin-film solar cell elements, and one stage of thin-film solar cell elements are in shade, as described above.

$$Rshpm = Vpm \text{ / } Ipm \times (n\text{-}1) \quad (2)$$

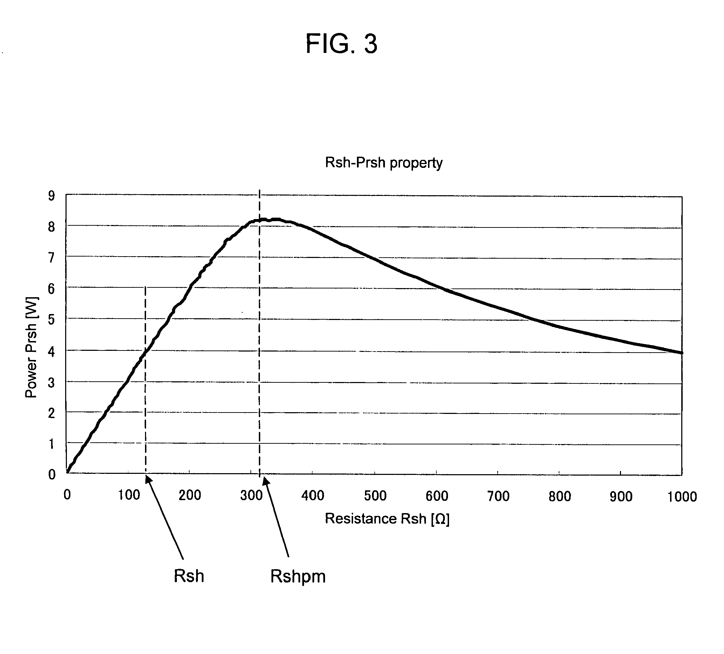

An actual short-circuit resistance Rsh is caused by various causes such as a region within the surface short-circuited by dust, flaws and protrusions, and a region of low resistance around the laser scribing. Rsh varies due to various reasons in a production step, distributed within a certain range. FIG. 3 illustrates the relationship between the short-circuit resistance Rsh and power Prsh consumed there according to I-V properties of a representative silicon thin-film solar cell. When the above-described short-circuit resistance Rsh is approximately 2.5 times the optimum load Rshpm, deviating from the optimum load Rshpm, the power Prsh decreases to half or less.

That is, in FIG. 3, the power is approximately 8 W when the optimum load Rshpm is approximately 330 Ω, and the power is approximately 4 W when the short-circuit resistance Rsh is 130 Ω. Therefore, it is possible to considerably reduce occurrence of peel-off due to a hotspot, if production can be carried out with the short-circuit resistance Rsh deviated from the optimum load Rshpm by 2.5 times or more. No matter how much the short-circuit load Rsh deviates from the optimum load Rshpm, it is acceptable as long as the deviation is by 2.5 times or more, because the deviation needs only to be by 2.5 times or more.

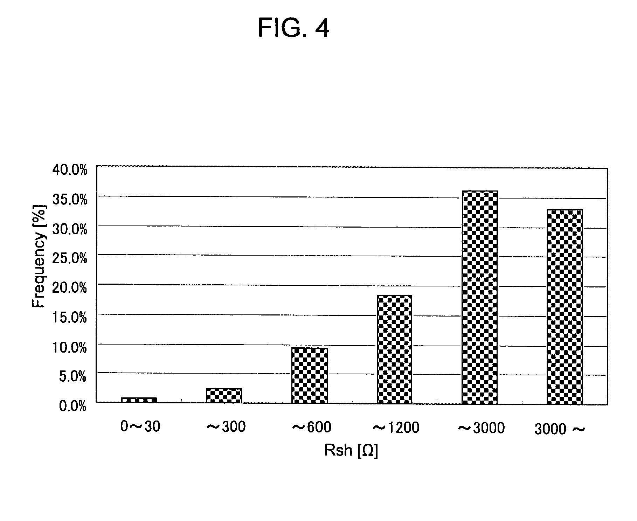

In addition, FIG. 4 illustrates distribution of the short-circuit resistance Rsh of a module actually produced. Factors that impair (= lower) the short-circuit resistance Rsh of the thin-film solar cell elements may include various events such as insufficient division at the dividing scribe lines; short circuit due to dust, protrusions, and pin holes within the surface; increase of reverse leakage current due to variation of production conditions; and lowered resistance of a doped layer. As a main factor around the peak of the distribution of short-circuit resistance Rsh (around 3000 Ω), however, leakage current at the dividing scribe lines mainly causes the lowering of the short-circuit resistance Rsh. In a range of the distribution of the short-circuit resistance Rsh lower than the vicinity of the peak, leakage current within the surface mainly causes the lowering of the short-circuit resistance Rsh.

When the factor of the leakage current is a short circuit within the surface, and a hotspot phenomenon occurs, the short-circuit region within the surface is peeled off or burnt off to cause high resistance. Therefore, F.F. of the cell is improved, offsetting lowering of Isc due to the peel-off. As a result, it is unlikely that the properties deteriorate significantly. However, when the factor of the leakage current is leakage current at the dividing scribe lines, and a hotspot phenomenon occurs, peel-off is generated from the dividing scribe lines. Then, solar cell elements in a normal region are involved to promote the peel-off or affect contact lines nearby. Therefore, in the case of leakage current at the dividing scribe lines, the properties and reliability of the thin-film solar cell module deteriorate significantly compared to the case of leakage current due to the short circuit within the surface.

It is therefore desirable that the above-mentioned optimum load Rshpm comes outside a range where the main factor is leakage current at the dividing scribe lines and stays within a range where the main factor is leakage current within the surface. Specifically, when the most frequent short-circuit resistance value Rsh is Rshm, the optimum load Rshpm needs to be within a range of sufficiently low level with respect to Rshm. Since the short-circuit resistance Prsh for the most frequent value Rshm is approximately half of the short-circuit resistance Prsh for the optimum load Rshpm when the most frequent value Rshm is 2.5 times the optimum load Rshpm, parameters need to be selected so that the following formula (3) is satisfied:

$$Rshm > 2.5 \times Rshpm = 2.5 \times Vpm \div Ipm \times (n\text{-}1) \qquad (3)$$

Once type, structure, and production conditions of the solar cell elements constituting the thin-film solar cell module are determined, Vpm, Ipm, and Rshm are almost determined, and then the following formula (1) is obtained by modifying the formula (3). Thereby, the maximum number of integration stages that can keep hotspot resistance is determined.

$$n < Rshm \div 2.5 \div Vpm \times Ipm + 1 \qquad (1)$$

Practically, Rshm > approximately 2000 $\Omega$ and Vpm / Ipm = approximately 5 to 10 $\Omega$ in reasonable solar cell elements, because too low short-circuit resistance Rsh affects solar cell element properties, though it depends on the form of the solar cell elements. Here, n < 80 to 160. In the case of solar cell elements for which the optimum operation voltage Vpm = approximately 1.0 V, any thin-film solar cell modules having an optimum operation voltage of approximately 80 to 160 V will naturally fall within the range.

The problem becomes significant only when the optimum operation voltage of the module is more than approximately 160 V. As a countermeasure for this case, we have found that the problem can be prevented if the number of integration stages is determined so as to meet the formula (1).

In addition, when the maximum number of integration stages is limited in this way and it is desired to obtain a voltage output higher than a voltage output that can be achieved with the number of integration stages as the thin-film solar cell module, the inside of the thin-film solar cell module is divided to a plurality of blocks so that the number of integration stages in each block falls within the range of the formula (1). Furthermore, if each block is provided with a bypass diode attached thereto in parallel and connected mutually in series, a thin-film solar cell module of high voltage output can be achieved, while ensuring its hotspot resistance. This is because the bypass diode, being attached in parallel, works at the time of the occurrence of hotspot to almost short-circuit the output of the block, thereby preventing influence of the other blocks.

The thin-film solar cell module of the present invention has the following configurations in embodiments thereof.

The optimum operation voltage of the thin-film solar cell string is more than 160 V.

The open-circuit voltage of the thin-film solar cell string is more than 160 V.

A plurality of thin-film solar cell strings are connected in parallel.

The plurality of thin-film solar cell strings are lined up in a direction in which the thin-film solar cell elements are connected in series.

The plurality of thin-film solar cell strings are lined up in a direction perpendicular to the direction in which the thin-film solar cell elements are connected in series.

The plurality of thin-film solar cell strings are lined up in both the direction in which the thin-film solar cell elements are connected in series and the direction perpendicular to the direction in which the thin-film solar cell elements are connected in series.

The plurality of thin-film solar cell strings are formed on one substrate.

The plurality of thin-film solar cell strings are connected in series, sharing a common electrode formed of their electrodes integrated on the supporting substrate.

The common electrode integrated constitutes a back surface electrode of the thin-film solar cell elements.

The thin-film solar cell strings are formed separately on a plurality of supporting substrates and sealed together into one.

The supporting substrates having the plurality of thin-film solar cell strings arranged thereon are sealed individually, and then integrated by a frame or a supporting plate.

Hereinafter, embodiments of the present invention will be described referring to the drawings.

<Embodiment 1>

- Embodiment of 53 stages $\times$ 12 parallels $\times$ 2 blocks in series -

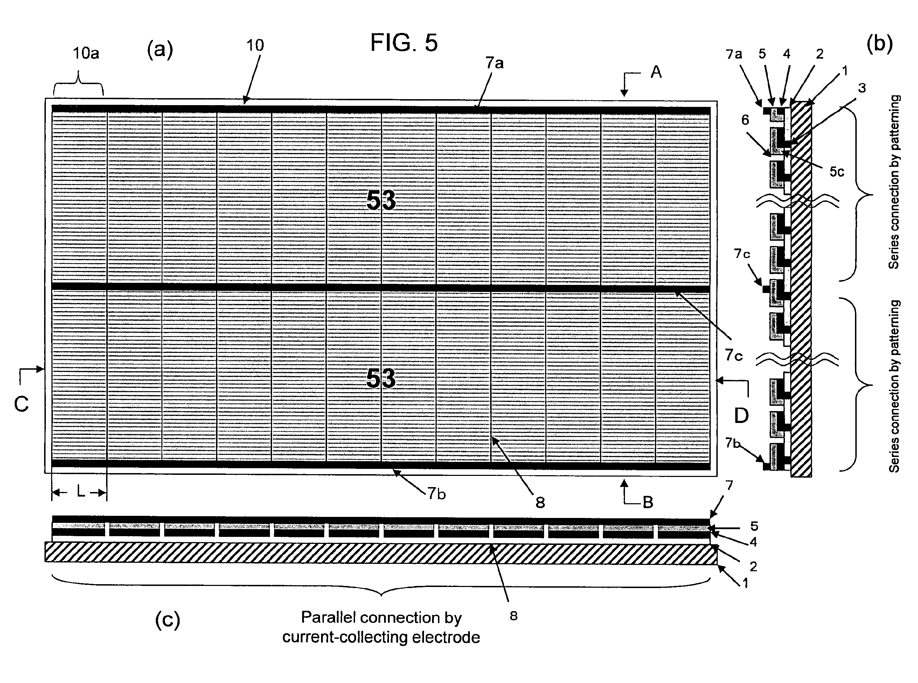

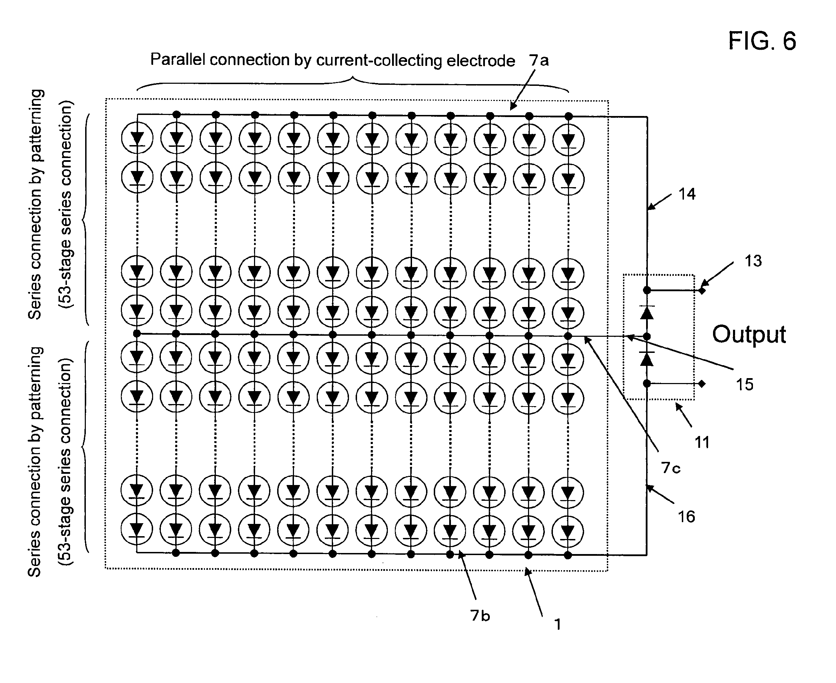

FIG. 5 illustrates an integrated thin-film solar cell module according to Embodiment 1 of the present invention, and FIG. 5 (a) is a plan view, FIG. 5 (b) is a cross-sectional view taken along lines A-B of FIG. 5 (a), and FIG. 5 (c) is a cross-sectional view taken along lines C-D of FIG. 5 (a). FIG. 6 illustrates a circuit diagram.

In Embodiment 1, a supporting substrate 1 is, for example, a translucent glass substrate or a resin substrate such as a polyimide. On the substrate (surface), a first electrode (for example, a transparent conductive film of $SnO_2$ (tin oxide)) is formed by a thermal CVD method or the like. As long as the first electrode is a transparent electrode, it may be, for example, ITO which is a mixture of $SnO_2$ and $In_2O_3$. Thereafter, the transparent conductive film is appropriately removed by patterning to form dividing scribe lines 3. Formation of the dividing scribe lines 3 forms the first electrode 2 that is divided into several pieces. The dividing scribe lines 3 are formed by cutting the first electrode by a groove-like shape (scribe line shape) by means of a laser scribing beam, for example.

Next, on the first electrode 2, a photoelectric conversion layer 4 is formed by forming a film of semiconductor layers (for example, amorphous silicon or microcrystalline silicon) of, for example, p-type, i-type, and n-type in sequence by a CVD method. At the same time, the dividing scribe lines 3 are also filled with the photoelectric conversion layer. The photoelectric conversion layer 4 may be of a p-n junction or a p-i-n junction. In addition, the photoelectric conversion layer 4 may be laminated into one, two, three, or more stages, and sensitivity of each solar cell element may be made to sequentially shift to a longer wavelength as it is distant from the substrate side. When the photoelectric conversion layer is laminated into a plurality of layers as described above, the layers may include a layer such as a contact layer and an intermediate reflection layer therebetween.

When the photoelectric conversion layer 4 is laminated into a plurality of layers, all the semiconductor layers may be an amorphous semiconductor or a microcrystalline semiconductor, or may be any combination of an amorphous semiconductor and a microcrystalline semiconductor. That is, the structure may be a laminate in which the first photoelectric conversion layer is of an amorphous semiconductor and the second and third photoelectric conversion layers are of a microcrystalline semiconductor. Or, the structure may be a laminate in which the first and second photoelectric conversion layers are of an amorphous semiconductor and the third photoelectric conversion layer is of a microcrystalline semiconductor. Or, the structure may be a laminate in which the first photoelectric conversion layer is of a microcrystalline semiconductor and the second and third photoelectric conversion layers are of an amorphous semiconductor.

In addition, while the above-described photoelectric conversion layer 4 is of a p-n junction or a p-i-n junction, it may be of an n-p junction or an n-i-p junction. Furthermore, the p-type semiconductor layer and the i-type semiconductor layer may or may not have a buffer layer of an i-type amorphous material therebetween. Usually, in the p-type semiconductor layer, a p-type impurity atom such as boron and aluminum is doped, and in the n-type semiconductor layer, an n-type impurity atom such as phosphorus is doped. The i-type semiconductor layer may be completely undoped or may be of a weak p-type or a weak n-type including a small amount of impurity.

The photoelectric conversion layer 4 is not limited to silicon, and may be formed of a silicon semiconductor such as silicon carbide containing carbon or silicon germanium containing germanium, or a compound semiconductor of a compound such as Cu(InGa)Se2, CdTe, and $CuInSe_2$.

Here, each photoelectric conversion layer 4 of Embodiment 1 is of a p-i-n junction, constituting a three-junction type thin-film solar cell of a laminate of three cells of amorphous silicon/amorphous silicon/microcrystalline silicon.

Then, connection grooves are formed on the photoelectric conversion layer 4 by laser scribing or the like, and a second electrode (ZnO/Ag electrode or the like) is formed thereon by sputtering or the like. As a result, the connection grooves are filled with the second electrode material, and contact lines 5c are formed. As a result, the second electrode 5 divided on the photoelectric conversion layer 4 and the adjacent first electrode 2 on the photoelectric conversion layer 4 will be connected via the contact lines 5c, and a plurality of thin-film solar cell elements will be connected in series. Furthermore, cell dividing grooves 6 are formed in parallel with the contact lines 5c by laser scribing or the like to divide the thin-film solar cell elements to a plurality of pieces. Thereby, in an example of FIG. 5, each individual solar cell element (cell) is divided to be in an equal size, and a thin-film solar cell string 10 (hereinafter, may be referred to as cell string) is formed, having a plurality of solar cell elements connected in series in the vertical direction of FIG. 5.

At this time, the dividing scribe lines 3, the contact lines 5c, and the cell dividing grooves 6 are formed so that the number of stages n of the series connection comes to an integral multiple of the following formula (1). That is, the number of stages n of the series connection of the thin-film solar cell elements in the cell string is determined to satisfy the following formula (1):

$$n < Rshm\ /\ 2.5\ /\ Vpm \times Ipm + 1 \qquad (1),$$

wherein Rshm is the most frequent short-circuit resistance value of the thin-film solar cell elements;
Vpm is an optimum operation voltage of the thin-film solar cell elements; and
Ipm is an optimum operation current of the thin-film solar cell elements.

Furthermore, cell string dividing grooves 8 running in the vertical direction of FIG. 5(a) are formed in the cell string 10 produced in that way to divide the cell string 10 to a plurality of pieces in the transverse direction of FIG. 5, thereby forming unit cell strings 10a. Here, the division to the unit cell strings is performed to hold power generation per unit cell string 10a to a certain value or lower for improvement of the hotspot resistance. The smaller output Pa of the unit cell strings 10a is, the better, in terms of prevention of damages to the cells due to a hotspot phenomenon. The upper limit of the output Pa of the unit cell strings is obtained by a cell hotspot resistance test to be described later, which is 12 W. The output Pa of the unit cell strings can be calculated according to the following formula (4):

$$Pa = (P\ /\ S) \times Sa \qquad (4),$$

wherein

P is the output of the thin-film solar cell module;
S is the area of the effective power generation region of the thin-film solar cell module; and
Sa is the area of the unit cell strings 10a.

In order to lower output Ps of the unit cell strings 10a when output P of the thin-film solar cell module is constant, the number of unit cell strings 10a included in the thin-film solar cell module needs to be increased, that is, the number of string dividing grooves 8 needs to be increased. The more the number of parallel division stages is, the more advantageous, when considering only the upper limit of the output Ps of the unit cell strings 10a. However, when the number of parallel division stages is increased, power density applied to the contact lines (P - Ps) / Sc increases, and the contact lines 5c become likely to be damaged for the following reasons (1) to (3). Here, P is the output of the thin-film solar cell module, Ps is the output possible from the cell string in shade, and Sc is the area of the contact lines 5c.

(1) Increase of power applied from the other unit cell strings

When one unit cell string 10a is in shade, power generated in all the other cell strings is applied to the unit cell string 10a in shade. The value of the power applied to the unit cell string 10a in shade is (P - Ps). When the number of parallel divisions is increased to reduce the output Pa of the unit cell string 10a, the power to be applied to the unit cell string 10a in shade increases, because the smaller the value of the output Pa of the unit cell string 10a is, the larger the value of the (P - Ps) is.

(2) Decrease of contact line area

When the number of parallel divisions is increased, a length L of the contact lines 5c illustrated in FIG. 5(b) is shortened, and, as a result, an area Sc of the contact lines 5c is made smaller. As a result, the value of resistance of the contact lines 5c increases.

(3) Increase of applied power density in connection grooves

As described above, the value of the (P - Ps) increases, and the area Sc of the contact P lines is made smaller, when the number of parallel divisions is increased. Therefore, the power density (P - Ps) /Sc applied to the contact lines 5c increases, and the contact lines 5c become likely to be damaged.
In order to prevent damage of the contact lines 5c, it is necessary to hold the power density (P - Ps) / Sc applied to the contact lines 5c to the upper limit thereof or lower. The upper limit of the power density (P - Ps) / Sc applied to the contact lines 5c can be determined according to the reverse overcurrent resistance test to be described later, which was 10.7 (kW/cm$^2$). The power density (P - Ps) / Sc applied to the contact lines is not limited in particular as long as it is 10.7 (kW/cm$^2$) or less.

Here, a cell hotspot resistance test will be described.

At first, thin-film solar cell modules of Embodiment 1 are produced and a reverse voltage of 5 V to 8 V is applied thereto, and the modules are measured for I-V and the current obtained when the reverse current is varied from 0.019 mA/cm$^2$ to 6.44 mA/cm$^2$ (referred to as RB current). Out of the measured samples, samples having different reverse currents are divided in parallel so that the output of the string to be evaluated is 5 to 50 W. Then, a hotspot resistance test is performed on a thin-film solar cell element (one cell). The hotspot resistance test was in accordance with ICE 61646, 1st EDITION. Here, however, the acceptance line was made severer by 10% in terms of an aim to make the appearance better. As for the peeled area, the area of a region where a film is peeled off was measured by photographing the sample surface from the substrate side of the thin-film solar cell module. Results of the measurement on the samples having different cell string outputs or RB currents have revealed that cases of moderate RB currents (0.31 to 2.06 mA/cm$^2$) are prone to peel-off of a film. It has been also revealed that the peeled area can be held to 5% or less regardless of the magnitude of the RB current, when the output of the cell string is 12 W or less. Thus, the output Ps of the unit cell string was set to 12 W or less.

Next, the reverse overcurrent resistance test will be described.

At first, thin-film solar cell modules of Embodiment 1 were produced, and the reverse overcurrent resistance test was performed by applying an overcurrent in a direction opposite to the direction of the power generation current and examining damage of the contact lines. According to the provisions of IEC 61730, the current to be applied here should be 1.35 times the anti-overcurrent specification value, and was set to 5.5 A at 70 V here.

When the above-specified voltage and current are applied to the thin-film solar cell module, the current is divided to be applied to the cell strings connected in parallel. However, the current is not divided equally, because the value of resistance varies from cell string to cell string. In the worst case, all the 5.5A at 70 V may be applied to one cell string. It is necessary to perform the test to see whether or not the cell string is damaged even in the worst case. Therefore, samples were produced with the width of the contact lines changed to 20 μm and 40 μm and the length of the contact lines changed to 8.2 mm to 37.5 cm to judge damage of the contact lines by visual inspection. As a result, it has been revealed that the area of the contact lines should be 20 μm × 18 cm or 40 μm × 9 cm = 0.036 cm$^2$ or more. The power applied to the cell strings is 385 W, which leads to 385 W ÷ 0.036 cm$^2$ = 10.7 (kW/cm$^2$).

After the string dividing grooves 8 are formed as described above, the cell string 10 is divided into two, upper and lower, regions by using a metal electrode 7. Specifically, a current-collecting electrode 7a is attached to the upper end in FIG. 5 and a current-collecting electrode 7b is attached to the lower end in FIG. 5, and the unit cell strings divided by the dividing grooves 8 running in the vertical direction are connected in parallel again. At the same time, a current-collecting electrode 7c for taking a center line is added between the two current-collecting electrodes 7a and 7b, dividing as a border the unit cell strings 10a into two, upper and lower, regions. Thereby, this integrated substrate 1 is divided to 12 × 2 = 24 regions. The current-collecting electrode 7c for taking a center line may be attached directly onto the second electrode 7 of the cell string as illustrated in FIG. 5(b). Alternatively, a space for an electrode for taking a center line may be provided between the upper region and the lower region for the attachment of the current-collecting electrode 7c.

FIG. 6 illustrates a circuit diagram of the thin-film solar cell module as a whole. Unit cell strings having a plurality of thin-film solar cell elements connected in series are connected to bypass diodes in parallel. Specifically, bypass diodes 12 are prepared in a terminal box 11, and lead wires 14, 15, 16 led out of each unit cell string 10a are arranged there to connect two cell strings to two bypass diodes 12 in parallel. Since the two bypass diodes 12 are connected in series, a plurality of cell strings are connected in series in a direction in which the plurality of thin-film solar cell elements are connected in series. Thereby, the number of series connections in the unit string can be held to the number of stages specified in the formula (1) or less and, at the same time, a two-fold voltage can be outputted between terminals 13. While each unit cell string is connected within the terminal box 11 in the above-described Embodiment 1, it may be connected onto a supporting substrate 1 of the thin-film solar cell module by providing and using a wire. In this case, the wire provided on the supporting substrate 1 may be formed at the same time as the formation of the current-collecting electrode 7, or a separate wire such as a jumper wire may be used.

When a three-junction type cell in which two amorphous silicon cells and one microcrystalline silicon cell are laminated is used for the photoelectric conversion layer in the configuration of Embodiment 1, the calculation shown in the formula (1) will be as follows:

$$Rshm = 4000 \ [\Omega]$$

$$Vpm = 1.80 \ [V]$$

$$Ipm = 62 \ [mA]$$

$$n < Rshm \div 2.5 \div Vpm \times Ipm + 1 = 56.1$$

Therefore, since n needs to be 56 stages or less according to the formula (1), Embodiment 1 is provided with the current-collecting electrode 7c for taking a center in the middle of its series structure of 106 stages, and each unit cell string 10a is of 53 stages.

In addition, while Embodiment 1 has one current-collecting electrode 7c for taking a center, the number of lines for taking a center may be increased by increasing the number of divisions according to the number of integration stages of the substrate as a whole and individual cell voltage so that the number of integration stages per region is decreased. Furthermore, one block is acceptable when the output voltage is equal to or lower than the voltage to be obtained according to the number of stages of the formula (1).

< Embodiment 2 >

- Embodiment of 53 stages $\times$ 6 parallels $\times$ 4 blocks in series -

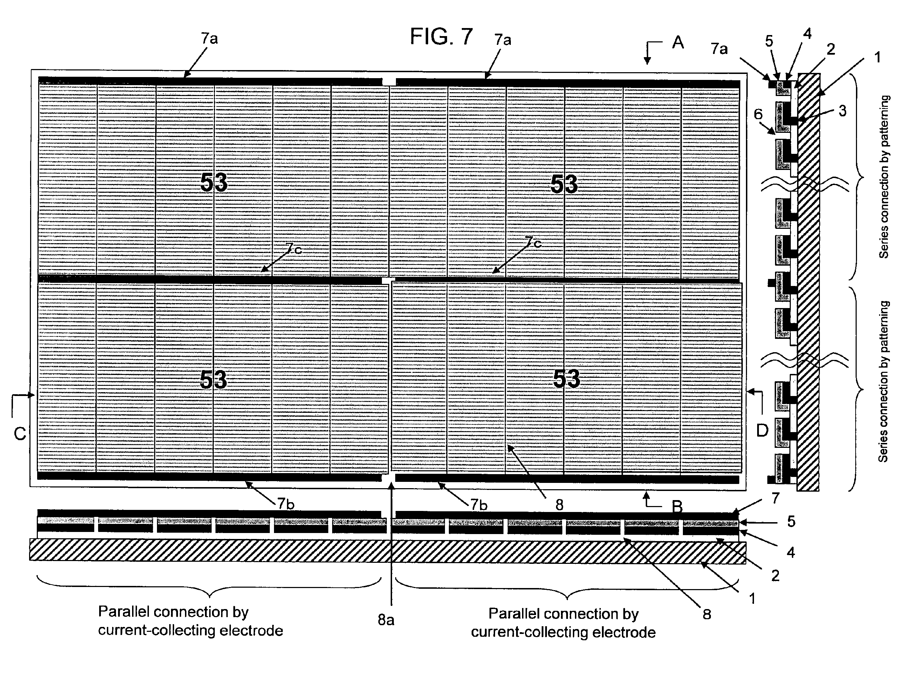

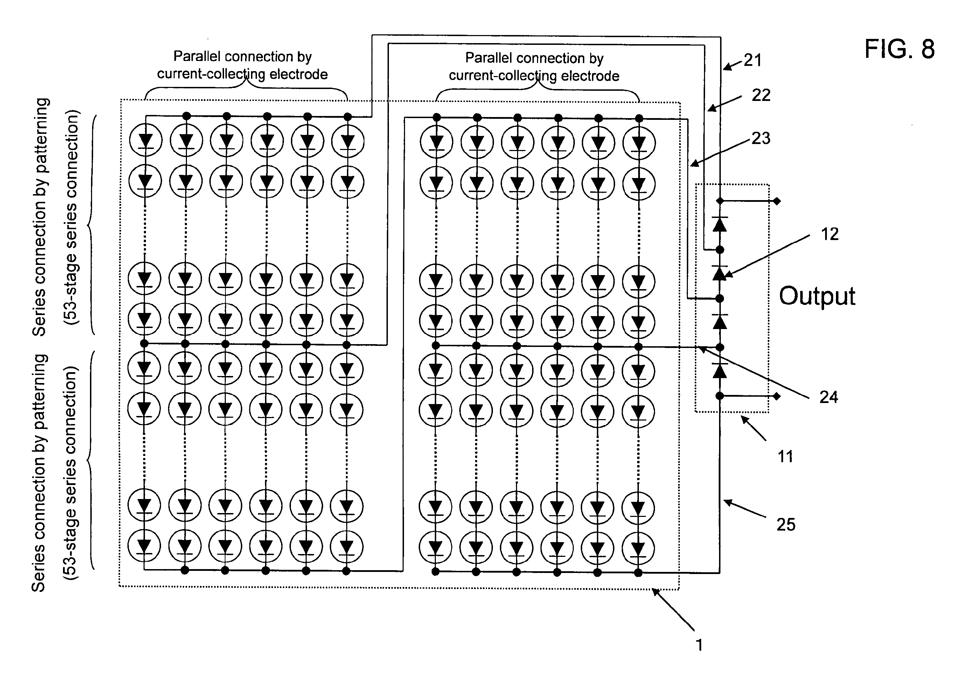

FIG. 7 illustrates an integrated thin-film solar cell module according to Embodiment 2 of the present invention, and FIG. 7(a) is a plan view, FIG. 7(b) is a cross-sectional view taken along lines E-F of FIG. 7(a), and FIG. 7(c) is a cross-sectional view taken along lines G-H of FIG. 7(a). FIG. 8 illustrates a circuit diagram.

Embodiment 2 is characterized in a connection method after division in order to output a higher voltage. The other configurations and the production method are the same as those of Embodiment 1. Specifically, processes up to the formation of the first electrode 2, the dividing scribe lines 3, the photoelectric conversion film 4, the second electrode 5, and the cell dividing grooves 6 are the same as those of Embodiment 1. Successively, the cell string is divided to 12 unit cell strings by the cell string dividing grooves 8 running in the vertical direction. At the time of the division, a middle string dividing groove 8a is made wider. Since a high voltage equivalent to half of the thin-film solar cell module operation voltage is applied to this part during power generation, it is necessary to ensure a breakdown voltage. In Embodiment 2, the string dividing groove 8a is approximately twice as wide as the other string dividing grooves 8. It is needless to say that the string dividing groove 8a may be filled with a resin, or an insulation film may be formed to increase a withstand voltage.

Thereafter, current-collecting electrodes 7a, 7b, 7c are formed separately so that each of them is divided into one for the cell string on the right in the drawing and one for the cell string on the left in the drawing to be independent electrodes. Thereby, four blocks of 53 stages of series connection $\times$ 6 parallels are completed. As shown in FIG. 8, wiring is made to the bypass diodes 12 within the terminal box 11 with the use of lead wires 21 to 25 to form a 4-block series connection. Thus, a thin-film solar cell module outputting a further voltage twice the voltage of Embodiment 1 can be achieved. In other words, an output voltage that is 4 times that of one cell string is obtained. Therefore, a plurality of cell strings are connected in series in a direction in which a plurality of thin-film solar cell elements are connected in series, and a plurality of cell strings are connected in series in a direction perpendicular to the direction in which a plurality of thin-film solar cell elements are connected in series. Thereby, the number of series connections in a unit cell string can be held to the number of stages specified in the formula (1) or less and, at the same time, a four-fold voltage can be outputted between the terminals 13.

As for the wiring for the 4-block series connection, lead wires led from each block may be directly connected within the thin-film solar cell module, lead wires led from each block may be connected within the terminal box as illustrated in FIG. 8, or the wires may be connected in series after once being brought to outside of the module.

In addition, the bypass diodes 12 are attached to every series block in parallel as in the case of Embodiment 1. Thereby, the number of series connections in one region can be held to the number of stages specified in the formula (1) or less and, at the same time, a four-fold voltage can be outputted. As for the bypass diodes 12, a small and thin type may be built in the thin-film solar cell module or may be built in the terminal box.

When the cell string is divided in a direction different from the integration direction of the solar cell elements, for example, in a direction perpendicular thereto, and the divided is reconnected as in the case of Embodiment 2, a higher voltage can be achieved while keeping an optimum integration pitch, that is, a higher voltage can be achieved without losing module conversion efficiency, unlike the case in which the division is made only in the integration direction as in the case of Embodiment 1.

< Embodiment 3 >

- Embodiment of 48 stages × 5 parallels × 4 blocks in series achieved by using two substrates of 48 stages × 5 parallels × 2 blocks in series -

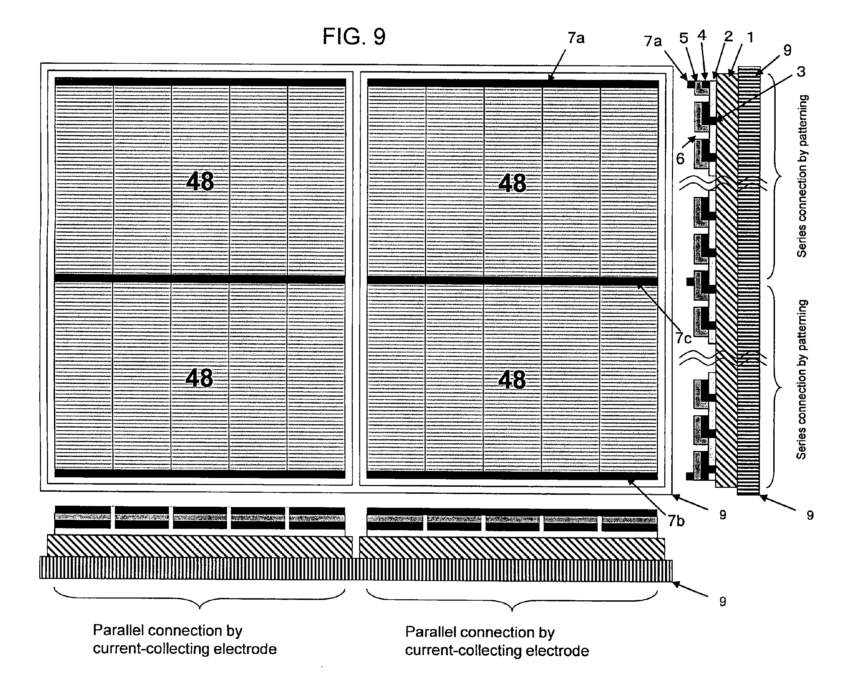

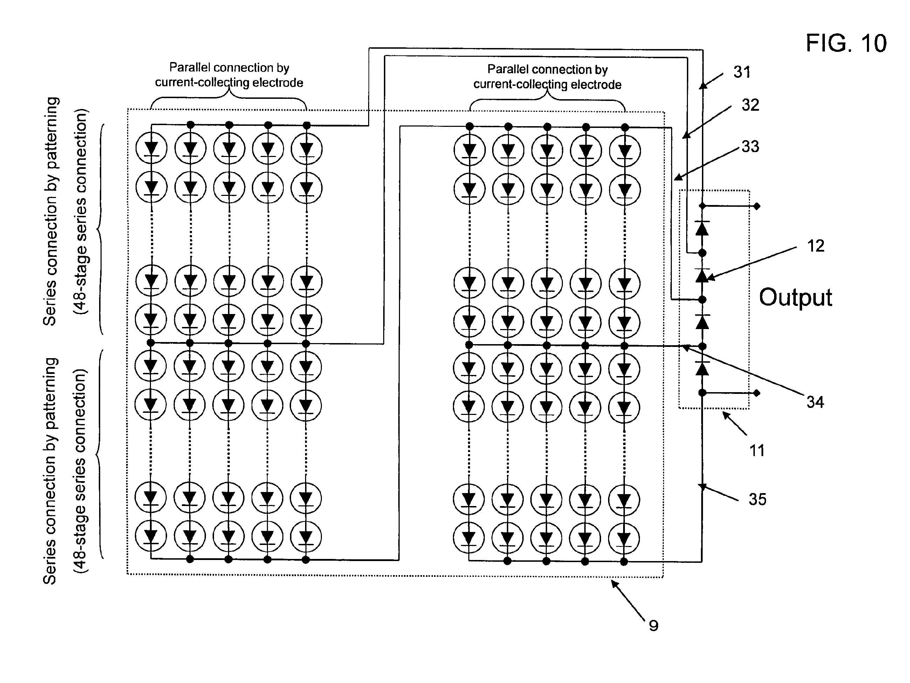

As for Embodiments 1 and 2, the supporting substrate itself is large, and have been described examples of the thin-film solar cell module in which all cell strings are formed on the substrate. However, even in the case where a plurality of small supporting substrates are combined to form a large solar cell module, similar problems will arise. In that case, a module of high voltage can be produced while ensuring reliability by forming cell strings in respective supporting substrates so that the requirement shown in the formula (1) is met and connecting the cell strings together. That is, the cell strings are formed in the same manner as in Embodiments 1 and 2, and arranged in two small sized integrated substrates connected in parallel on one integrated substrate 9 as illustrated in FIG. 9. That is, two supporting substrates 1 of the thin-film solar cell module are mounted on the integrated substrate 9 formed of one cover glass, and configured to be integrated together as illustrated in FIG. 9. And, they are connected in series in the terminal box 11 as illustrated in FIG. 10.

The above-described small supporting substrates may be sealed separately to be integrated on the integrated substrate as illustrated in FIG. 9, or may be integrated by using a frame. Or, the two small supporting substrates may be mounted on one integrated substrate and sealed to be integrated together as described above. Or, the two supporting substrates may be sealed separately and integrated with the use of a frame to form one thin-film solar cell module.

As for the above-described Embodiments, a thin-film solar cell module of a superstraight structure has been described. However, a thin-film solar cell module of a sub-straight structure is also applicable. In that case, the second electrode, the photoelectric conversion layer, and the first electrode are formed on the substrate in this order

In addition, while the above-described Embodiments are each provided with one terminal box, they may be each provided with a plurality of terminal boxes, and a plurality of terminal books may be wired to connect the cell strings in series.

Furthermore, as for the above-described Embodiments, two cell strings are formed and divided into two; however, one cell string may be acceptable when the output voltage is satisfiable by the number of stages n of the cell strings. Moreover, the number of cell strings does not need to be an even number, and may be an odd number.

In addition, as for the above-described Embodiments, the cell strings are connected in series through the connection to the bypass diodes; however, other protective circuits than the bypass diodes may be used. For example, electronic diode-less protective circuits may be used.

## Claims

1.   A thin-film solar cell module comprising:

   a thin-film solar cell string comprising a plurality of thin-film solar cell elements interconnected in series, each of the thin-film solar cell elements including a surface electrode, a photoelectric conversion layer, and a back surface electrode laminated in this order, the thin-film solar cell module being configured so that a number of stages n of the series connection of the thin-film solar cell elements in the thin-film solar cell string satisfies the following formula (1):

$$n < Rshm / 2.5 / Vpm \times Ipm + 1 \quad (1),$$

   wherein Rshm is a most frequent short-circuit resistance value of the thin-film solar cell elements;
   Vpm is an optimum operation voltage of the thin-film solar cell elements; and
   Ipm is an optimum operation current of the thin-film solar cell elements.

**2.** The thin-film solar cell module according to Claim 1, wherein the optimum operation voltage of the thin-film solar cell string is more than 160 V.

**3.** The thin-film solar cell module according to Claim 1 or 2, wherein a plurality of the thin-film solar cell strings are connected in parallel.

**4.** The thin-film solar cell module according to any one of Claims 1 to 3, wherein a plurality of the thin-film solar cell strings are connected in parallel and provided with a bypass diode connected thereto in parallel, and a plurality of the thin-film solar cell strings parallel-connected and provided with the bypass diode are connected in series.

**5.** The thin-film solar cell module according to any one of Claims 1 to 4, wherein the plurality of thin-film solar cell strings are lined up in a direction in which the thin-film solar cell elements are connected in series.

**6.** The thin-film solar cell module according to any one of Claims 1 to 4, wherein the plurality of thin-film solar cell strings are lined up in a direction perpendicular to a direction in which the thin-film solar cell elements are connected in series.

**7.** The thin-film solar cell module according to any one of Claims 1 to 4, wherein the plurality of thin-film solar cell strings are lined up in both a direction in which the thin-film solar cell elements are connected in series and a direction perpendicular to the direction in which the thin-film solar cell elements are connected in series.

**8.** The thin-film solar cell module according to any one of Claims 1 to 7, wherein the plurality of thin-film solar cell strings are formed on one substrate.

**9.** The thin-film solar cell module according to Claim 8, wherein the plurality of thin-film solar cell strings are connected in series, sharing a common electrode formed of their electrodes integrated on a supporting substrate.

**10.** The thin-film solar cell module according to Claim 8, wherein the common electrode integrated constitutes a back surface electrode of the thin-film solar cell elements.

**11.** The thin-film solar cell module according to any one of Claims 1 to 7, wherein the thin-film solar cell strings are formed separately on a plurality of supporting substrates and sealed together into one.

**12.** The thin-film solar cell module according to any one of Claims 1 to 11, wherein the thin-film solar cell strings are sealed individually, and then integrated by a frame or a supporting plate.

FIG. 1(a)

FIG. 1(b)

FIG. 2

Cell in light

$I1 = f(v) = Iph - Id - Irsh$

Iph, Id, Irsh, Vd

Cell in shade

$I1 = f(v) = -Id - Irsh$

Id1, Irsh, Vd1

It2

I-V of cell in light

I-V of cell in shade
Slope=1/Rsh

Vd1

14

## FIG. 3

Rsh-Prsh property

FIG. 4

EP 2 246 899 A1

FIG. 5

Series connection by patterning

Series connection by patterning

Parallel connection by current-collecting electrode

## FIG. 6

FIG. 7

Series connection by patterning

Series connection by patterning

Parallel connection by current-collecting electrode

Parallel connection by current-collecting electrode

FIG. 8

Parallel connection by current-collecting electrode

Parallel connection by current-collecting electrode

Series connection by patterning (53-stage series connection)

Series connection by patterning (53-stage series connection)

Output

21
22
23
12
24
11
25
1

## FIG. 9

Series connection by patterning

Series connection by patterning

Parallel connection by
current-collecting electrode

Parallel connection by
current-collecting electrode

FIG. 10

| | |
|---|---|
| **INTERNATIONAL SEARCH REPORT** | International application No. |
| | PCT/JP2009/052692 |

A. CLASSIFICATION OF SUBJECT MATTER
*H01L31/04(2006.01)i*

According to International Patent Classification (IPC) or to both national classification and IPC

B. FIELDS SEARCHED

Minimum documentation searched (classification system followed by classification symbols)
H01L31/04

Documentation searched other than minimum documentation to the extent that such documents are included in the fields searched

| Jitsuyo Shinan Koho | 1922-1996 | Jitsuyo Shinan Toroku Koho | 1996-2009 |
|---|---|---|---|
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 7-99334 A (Canon Inc.), 11 April, 1995 (11.04.95), Par. Nos. [0017] to [0018] (Family: none) | 1-12 |
| X | JP 2002-141540 A (Canon Inc.), 17 May, 2002 (17.05.02), Par. No. [0048] & US 2002/0050290 A1 & EP 1202354 A2 | 1-12 |
| X | JP 2001-68713 A (Kaneka Corp.), 16 March, 2001 (16.03.01), Par. Nos. [0043] to [0050] & US 6288323 B1 & EP 1079441 A3 & EP 1079441 A2 | 1-12 |

| | |
|---|---|
| ☒ Further documents are listed in the continuation of Box C. | ☐ See patent family annex. |

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| | |
|---|---|
| Date of the actual completion of the international search 10 March, 2009 (10.03.09) | Date of mailing of the international search report 24 March, 2009 (24.03.09) |
| Name and mailing address of the ISA/ Japanese Patent Office | Authorized officer |
| Facsimile No. | Telephone No. |

Form PCT/ISA/210 (second sheet) (April 2007)

## INTERNATIONAL SEARCH REPORT

| International application No. |
| --- |
| PCT/JP2009/052692 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 2000-270592 A  (San'yo Denshi Shisutemu Kabushiki Kaisha), 29 September, 2000 (29.09.00), Par. Nos. [0014] to [0015] (Family: none) | 1-12 |
| A | JP 2004-311883 A  (Canon Inc.), 04 November, 2004 (04.11.04), Par. Nos. [0068], [0075] (Family: none) | 1-12 |
| A | JP 2006-49552 A  (Fuji Electric Holdings Co., Ltd.), 16 February, 2006 (16.02.06), Par. Nos. [0024], [0029] (Family: none) | 1-12 |

Form PCT/ISA/210 (continuation of second sheet) (April 2007)

**EP 2 246 899 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001068713 A